# EUROPÄISCHE PATENTSCHRIFT

(11) **EP 2 258 029 B1**
(45) Veröffentlichungstag und Bekanntmachung des Hinweises auf die Patenterteilung: **07.11.2018**
(21) Anmeldenummer: 09726832.0
(22) Anmeldetag: 09.03.2009
(51) Int. Cl.: H01S 5/22

(54) **VERFAHREN ZUR HERSTELLUNG EINES HALBLEITERBAUELEMENTS**
METHOD FOR PRODUCING A SEMICONDUCTOR COMPONENT
PROCÉDÉ DE FABRICATION D'UN COMPOSANT SEMICONDUCTEUR

(30) Priorität: 31.03.2008 DE 102008016489; 30.04.2008 DE 102008021674
(43) Veröffentlichungstag der Anmeldung: 08.12.2010
(73) Patentinhaber: OSRAM Opto Semiconductors GmbH, 93055 Regensburg (DE)
(72) Erfinder: EICHLER, Christoph, 93105 Tegernheim (DE); STRAUSS, Uwe, 93077 Bad Abbach (DE)
(74) Vertreter: Epping - Hermann - Fischer
(86) Internationale Anmeldenummer: PCT/DE2009/000334
(87) Internationale Veröffentlichungsnummer: WO 2009/121315

(56) Entgegenhaltungen:
- WO-A-2006/051272
- JP-A- 2003 229 412
- JP-A- 2006 165 421
- JP-A- 2006 279 079
- US-A1- 2002 094 002
- US-A1- 2007 030 869
- US-A1- 2008 056 321
- US-B1- 6 266 354

## Beschreibung

Die vorliegende Anmeldung betrifft ein Verfahren zur Herstellung eines Halbleiterbauelements.

Kantenemittierende Halbleiterlaserdioden in Rippenwellenleitergeometrie (ridge waveguide laser diodes) weisen typischerweise einen stegförmigen Bereich auf, der insbesondere zur Wellenführung in lateraler Richtung vorgesehen ist. Zur Herstellung dieses stegförmigen Bereichs kann Halbleitermaterial bereichsweise mit einem Ätzverfahren entfernt werden, wobei die Ätztiefe über die Dauer des Ätzprozesses eingestellt werden kann. In lateraler Richtung auftretende Inhomogenitäten der Materialzusammensetzung und der Dicke des Halbleitermaterials, etwa aufgrund von Schwankungen im Herstellungsprozess erschweren hierbei ein gleichmäßiges und reproduzierbares Ausbilden eines stegförmigen Bereichs mit einer vorgegebenen Höhe. Dies kann zu Schwankungen bei Betriebskenngrößen für die Halbleiterlaser, etwa bei der Laserschwelle, der Steilheit der Leistungs-Strom-Kennlinie und dem Modenverhalten führen. Die Druckschrift WO 2006/051272 A1 betrifft ein Verfahren, bei dem ein Substrat stellenweise mit Hilfe einer Indikatorschicht entfernt wird. Mit diesem Verfahren werden Laserdioden mit einem Vertikalemitter, kurz VSCELs,

Die Druckschrift JP 2006 165421 A betrifft ein Verfahren gemäß dem Oberbegriff des Anspruchs 1.

Es ist eine Aufgabe, ein Verfahren anzugeben, mit dem ein Halbleiterbauelement auf einfache Weise zuverlässig hergestellt werden kann.

Diese Aufgaben wird durch das Verfahren des Anspruchs 1 gelöst. Ausgestaltungen und Weiterbildungen sind Gegenstand der abhängigen Patentansprüche.

Ein mit dem Verfahren hergestelltes Halbleiterbauelement umfasst einen Halbleiterkörper mit einer Halbleiterschichtenfolge, die einen zur Erzeugung von kohärenter Strahlung vorgesehenen aktiven Bereich und eine Indikatorschicht aufweist. Der Halbleiterkörper weist eine Grenzfläche auf, die den Halbleiterkörper in vertikaler Richtung bereichsweise begrenzt. Auf der dem aktiven Bereich abgewandten Seite der Grenzfläche weist der Halbleiterkörper einen stegartigen Bereich auf, der sich in vertikaler Richtung zwischen der Grenzfläche und einer Oberfläche des Halbleiterkörpers erstreckt. Die Indikatorschicht weist eine Materialzusammensetzung auf, die von derjenigen des an die Indikatorschicht angrenzenden Materials des stegartigen Bereichs verschieden ist. Ein Abstand der Indikatorschicht von der Oberfläche ist höchstens so groß wie ein Abstand der Grenzfläche von der Oberfläche.

Der Abstand der Indikatorschicht vom aktiven Bereich ist bereits bei der vorzugsweise epitaktischen Abscheidung der Halbleiterschichtenfolge des Halbleiterkörpers einstellbar. Die Ausbildung des stegartigen Bereichs kann, insbesondere hinsichtlich seiner Ausdehnung in vertikaler Richtung und/oder seines Abstands zum aktiven Bereich, auf besonders reproduzierbare Weise erfolgen, wobei die vertikale Ausdehnung des stegartigen Bereichs mindestens so groß ist wie der Abstand der Indikatorschicht von der Oberfläche.

In einer Ausgestaltungsvariante ist die Grenzfläche mittels der Indikatorschicht gebildet. Der Abstand der Indikatorschicht von der Oberfläche kann hierbei dem Abstand der Grenzfläche von der Indikatorschicht entsprechen oder zumindest nahe kommen. Beispielsweise kann der Abstand einer dem aktiven Bereich abgewandten Oberseite der Indikatorschicht von der Grenzfläche höchstens 100 nm, bevorzugt höchstens 50 nm betragen.

Insbesondere kann die Oberseite der Indikatorschicht die Grenzfläche bilden. Die Oberseite kann weiterhin als eine planare oder im Wesentlichen planare Fläche ausgebildet sein, die den stegartigen Bereich von der Indikatorschicht trennt. Somit ist der Abstand der Grenzfläche vom aktiven Bereich im Wesentlichen bereits bei der Abscheidung des Halbleiterkörpers durch den Abstand der Oberseite der Indikatorschicht vom aktiven Bereich vorgegeben.

In einer weiteren Ausgestaltungsvariante beträgt ein Abstand der Indikatorschicht von der Grenzfläche höchstens 70 nm. Mit anderen Worten ist ein Abstand einer dem aktiven Bereich zugewandten Unterseite der Indikatorschicht vom aktiven Bereich höchstens 70 nm größer als ein Abstand der Grenzfläche vom aktiven Bereich. Die Indikatorschicht kann in diesem Fall vollständig innerhalb des stegartigen Bereichs angeordnet sein.

Unter einem stegartigen Bereich wird insbesondere ein Bereich verstanden, der in lateraler Richtung eine geringere Ausdehnung aufweist als der aktive Bereich. Der aktive Bereich ragt also in lateraler Richtung zumindest bereichsweise über den stegartigen Bereich hinaus.

Als laterale Richtung wird eine Richtung angesehen, die in einer Haupterstreckungsebene der Halbleiterschichten des Halbleiterkörpers und senkrecht zu einer Hauptausbreitungsrichtung der im Betrieb im aktiven Bereich erzeugten und insbesondere zu verstärkenden Strahlung verläuft.

Entsprechend wird unter einer vertikalen Richtung eine Richtung verstanden, die senkrecht zu der Haupterstreckungsebene der Halbleiterschichten des Halbleiterkörpers verläuft.

In einer bevorzugten Ausgestaltung weist der Halbleiterkörper eine Ladungsträgerbarriere auf, die auf der dem stegartigen Bereich zugewandten Seite des aktiven Bereichs ausgebildet ist. Eine strahlende Rekombination von Ladungsträgern, die im Betrieb des Halbleiterbauelements in den Halbleiterkörper injiziert werden, kann so verbessert auf den aktiven Bereich beschränkt werden. Die Schwelle für den Betriebsstrom, bei der die Erzeugung kohärenter Strahlung einsetzt, kann erniedrigt werden.

In einer Ausgestaltungsvariante ist die Ladungsträgerbarriere mittels der Indikatorschicht gebildet. Die Indikatorschicht kann also zusätzlich zu der vereinfachten Ausbildung des stegartigen Bereichs dazu dienen, dass die Rekombination von Ladungsträgern innerhalb des aktiven Bereichs effizient erfolgt.

In einer alternativen Ausgestaltungsvariante ist die Indikatorschicht von der Ladungsträgerbarriere beabstandet. Insbesondere kann die Indikatorschicht einen größeren Abstand vom aktiven Bereich aufweisen als die Ladungsträgerbarriere. Die Indikatorschicht kann also auf der dem aktiven Bereich abgewandten Seite der Ladungsträgerbarriere ausgebildet sein.

Indikatorschicht und Ladungsträgerbarriere können so, etwa hinsichtlich ihrer Materialzusammensetzung, unabhängig voneinander gewählt werden. Weiterhin ist so der Abstand des stegartigen Bereichs vom aktiven Bereich weitgehend unabhängig von der Position der Ladungsträgerbarriere einstellbar.

Die Ladungsträgerbarriere weist vorzugsweise für den einen Ladungstyp eine größere Durchlässigkeit auf als für den anderen Ladungstyp. Beispielsweise kann die Ladungsträgerbarriere als eine Elektronenbarriere ausgebildet sein, die Löcher ungehindert oder zumindest weitgehend ungehindert durchlässt. Eine Elektronenbarriere ist vorzugsweise in einem p-leitenden Bereich der Halbleiterschichtenfolge angeordnet oder grenzt an einen p-leitenden Bereich an. Insbesondere kann eine Elektronenbarriere selbst p-leitend dotiert sein.

Entsprechend ist eine Löcherbarriere vorzugsweise in einem n-leitenden Bereich angeordnet oder grenzt an einen n-leitenden Bereich an und ist weiterhin bevorzugt n-leitend dotiert.

Auf der dem stegartigen Bereich zugewandten Seite des aktiven Bereichs ist eine Wellenleiterschicht ausgebildet. Die Wellenleiterschicht ist zur Führung der im aktiven Bereich zu erzeugenden und/oder zu verstärkenden Strahlung in vertikaler Richtung vorgesehen.

Die Indikatorschicht kann zwischen der Wellenleiterschicht und dem aktiven Bereich angeordnet sein. Mit anderen Worten kann die Wellenleiterschicht auf der dem aktiven Bereich abgewandten Seite der Indikatorschicht angeordnet sein. Ein Abstand der Wellenleiterschicht vom aktiven Bereich ist so mittels der Indikatorschicht auf einfache Weise einstellbar. Weiterhin kann sich in diesem Fall der stegartige Bereich in die Wellenleiterschicht hinein erstrecken.

Die Indikatorschicht kann auch auf der dem aktiven Bereich abgewandten Seite der Wellenleiterschicht angeordnet sein. In diesem Fall kann die Wellenleiterschicht außerhalb des stegartigen Bereichs ausgebildet sein.

Weiterhin kann die Indikatorschicht auch in der Wellenleiterschicht ausgebildet sein. In diesem Fall kann also beidseits der Indikatorschicht Material der Wellenleiterschicht angeordnet sein.

Unter einer Indikatorschicht wird eine Schicht verstanden, die bei einem trockenchemischen Abtragverfahren gegenüber einer in Abtragrichtung vorgeordneten Schicht eine signifikante Änderung zumindest einer Eigenschaft eines Prozessgases bewirkt. Durch Überwachen dieser Eigenschaft wird so bei der Herstellung auf genaue und reproduzierbare Weise ermittelt, wann die Indikatorschicht erreicht ist.

In einer bevorzugten Ausgestaltung enthält die Indikatorschicht ein Material, das gegenüber einem trockenchemischen Abtragverfahren eine höhere Beständigkeit aufweist als das auf der dem aktiven Bereich abgewandten Seite der Indikatorschicht, insbesondere unmittelbar angrenzende, Material. Das Ausbilden eines stegartigen Bereichs, der sich in vertikaler Richtung bis zu einem vorgegebenen Abstand vom aktiven Bereich erstreckt, kann so vereinfacht realisiert werden.

Der Halbleiterkörper enthält ein III-V-Verbindungshalbleitermaterial. Mit III-V-Halbleitermaterialien können bei der Strahlungserzeugung hohe interne Quanteneffizienzen erzielt werden. Der Halbleiterkörper enthält ein nitridisches Verbindungshalbleitermaterial.

Unter dem nitridischen Verbindungshalbleitermaterial wird ein Material verstanden, das ein Nitrid-III/V-Verbindungshalbleitermaterial, also AlₓIn_{y}Ga_{1x-y}N umfasst, wobei 0 ≤ x ≤ 1, 0 ≤ y ≤ 1 und x + y ≤ 1 gilt, insbesondere mit x ≠ 1, y ≠ 1, x ≠ 0 und/oder y ≠ 0. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₓIn_{y}Ga_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Nitridische Verbindungshalbleitermaterialien sind zur Strahlungserzeugung im ultravioletten über den blauen bis in den grünen Spektralbereich besonders geeignet.

In einer bevorzugten Ausgestaltung weist die Indikatorschicht eine Zusammensetzung auf, die bezüglich eines Gruppe-III-Materials, etwa Aluminium, Indium oder Gallium, um mindestens 10 Prozentpunkte, besonders bevorzugt eine um mindestens 20 Prozentpunkte, von der Zusammensetzung einer an die Indikatorschicht angrenzenden Halbleiterschicht des stegartigen Bereichs verschieden ist. Je größer der Unterschied in der Materialzusammensetzung ist, desto stärker können bei der Herstellung die Abtragraten für diese Halbleiterschichten voneinander abweichen.

In einer bevorzugten Weiterbildung weist die Indikatorschicht einen höheren Aluminiumgehalt auf als die an die Indikatorschicht angrenzende Halbleiterschicht des stegartigen Bereichs. In einer Weiterbildung, die nicht erfindungsgemäß ist, beträgt der Aluminiumgehalt der Indikatorschicht mindestens 20 %, besonders bevorzugt mindestens 30 %. Erfindungsgemäß beträgt der Aluminiumgehalt der Indikatorschicht mindestens 50 %.

Erfindungsgemäß enthält die Indikatorschicht ein nitridisches Verbindungshalbleitermaterial und ist bezogen auf Galliumnitrid gitterangepasst. Die relative Abweichung der Gitterkonstante der Indikatorschicht von der Gitterkonstante von Galliumnitrid beträgt höchstens 5 %, besonders bevorzugt höchstens 3 %. Insbesondere die Verspannung eines Halbleiterkörpers mit einem auf einem nitridischen Verbindungshalbleitermaterial basierenden aktiven Bereich kann so vermindert werden.

In einer weiteren bevorzugten Ausgestaltung ist zumindest auf einer Seite des aktiven Bereichs eine Mantelschicht angeordnet. Die Mantelschicht weist vorzugsweise einen geringeren Brechungsindex auf als die Wellenleiterschicht. Eine Wellenführung der im Betrieb des Halbleiterbauelements im aktiven Bereich erzeugten Strahlung in der Wellenleiterschicht wird so vereinfacht.

Weiterhin bevorzugt enthält die Mantelschicht oder zumindest eine Teilschicht der Mantelschicht AlₓIn_{y}Ga_{1-x-y}N mit einem von Null verschiedenen Indium-Gehalt.

Weiterhin bevorzugt beträgt der Galliumgehalt höchstens 10 %, so dass 1-x-y ≤ 0.1 gilt. Die Mantelschicht oder zumindest die Teilschicht der Mantelschicht kann weiterhin bezogen auf Galliumnitrid gitterangepasst sein.

In einer weiteren bevorzugten Ausgestaltung beträgt ein Abstand der Indikatorschicht vom aktiven Bereich höchstens 400 nm, besonders bevorzugt höchstens 300 nm. Der Abstand kann weitergehend verringert sein und höchstens 150 nm, bevorzugt höchstens 120 nm, am meisten bevorzugt höchstens 70 nm, betragen. Der stegartige Bereich kann so besonders nahe am aktiven Bereich ausgebildet werden. Insbesondere kann eine derart nah am aktiven Bereich angeordnete Indikatorschicht als Ladungsträgerbarriere ausgebildet sein.

In einer weiteren bevorzugten Ausgestaltung verläuft eine Seitenfläche des stegartigen Bereichs in einem Winkel von höchstens 30° zu einer Senkrechten auf die Haupterstreckungsebene der Halbleiterschichten des Halbleiterkörpers. Insbesondere kann die Seitenfläche senkrecht oder im Wesentlichen senkrecht, etwa mit einer Abweichung von der Senkrechten um höchstens 10°, zu der Haupterstreckungsebene des aktiven Bereichs, verlaufen. Weiterhin kann die Seitenfläche parallel zu einer Hauptausbreitungsrichtung der im aktiven Bereich erzeugten Strahlung verlaufen. Insbesondere kann die Seitenfläche senkrecht oder im Wesentlichen senkrecht zu einer Auskoppelfläche für die Strahlung verlaufen.

Erfindungsgemäß ist das Halbleiterbauelement als Halbleiterlaserbauelement in Rippenwellenleitergeometrie, ausgeführt.

Beim Verfahren zur Herstellung des Halbleiterbauelements wird erfindungsgemäß eine Halbleiterschichtenfolge mit einem zur Erzeugung von Strahlung vorgesehenen aktiven Bereich und einer Indikatorschicht bereitgestellt. Auf der dem aktiven Bereich abgewandten Seite der Indikatorschicht wird mittels trockenchemischen Abtragens der Halbleiterschichtenfolge bereichsweise entfernt, wobei eine Eigenschaft eines Prozessgases während des Abtragens überwacht wird und das Erreichen der Indikatorschicht mittels der Änderung der Eigenschaft des Prozessgases ermittelt wird.

Der Begriff Prozessgas umfasst in diesem Zusammenhang in weiter Bedeutung nicht-ionisiertes, teil-ionisiertes und ionisiertes Gas (Plasma), das weiterhin abgetragenes Halbleitermaterial enthalten kann.

Als trockenchemisches Abtragverfahren eignet sich beispielsweise reaktives Ionen-Ätzen (reactive ion etching, RIE) oder chemisch assistiertes Ionenstrahl-Ätzen (chemical assisted ion beam etching, CAIBE).

Insbesondere kann bei diesem Verfahren ein in vertikaler Richtung weitergehendes Abtragen des Halbleitermaterials beendet oder zumindest stark reduziert werden, sobald die Indikatorschicht erreicht ist. Die Dicke des auf dem aktiven Bereich verbleibenden Halbleitermaterials kann also bereits bei der Abscheidung der Halbleiterschichtenfolge über die Dicke und den Abstand der Indikatorschicht vom aktiven Bereich eingestellt werden.

Mit anderen Worten kann bei dem beschriebenen Verfahren eine vorgegebene Abtragtiefe beziehungsweise ein vorgegebener Abstand vom aktiven Bereich weitgehend unabhängig von der tatsächlichen Abtragrate eingestellt werden.

In einer bevorzugten Ausgestaltung wird mittels der überwachten Eigenschaft des Prozessgases eine Änderung der Materialzusammensetzung des abgetragenen Halbleitermaterials ermittelt.

Die überwachte Eigenschaft kann insbesondere die spektrale Abstrahlcharakteristik des Prozessgases sein. Je nach der Zusammensetzung des Prozessgases kann hierbei das abgetragene Material in zumindest einem spektralen Bereich eine für das Material charakteristische Abstrahlung bewirken. Bevorzugt ist die Stärke dieser Abstrahlung umso höher, je größer die Menge des Materials in dem Prozessgas ist.

In einer weiteren bevorzugten Ausgestaltung sind das trockenchemische Abtragverfahren und die Indikatorschicht derart aufeinander abgestimmt, dass Material auf der Indikatorschicht langsamer abgetragen wird als Material, das der Indikatorschicht in Abtragrichtung gesehen unmittelbar vorgeordnet ist. Weitergehend kann das trockenchemische Abtragverfahren bezüglich des Materials derart selektiv sein, dass das Abtragverfahren auf Höhe der Indikatorschicht stoppt oder zumindest derart verlangsamt wird, dass kein signifikanter Abtrag der Indikatorschicht erfolgt. Die Indikatorschicht kann also die Funktion einer Stoppschicht für das Abtragverfahren erfüllen. Das Freilegen der Indikatorschicht in den vorgegebenen Bereichen kann so weitgehend unabhängig von der Dicke des auf der Indikatorschicht angeordneten Materials sein. Auch bei einer inhomogenen Schichtdicke und/oder einer inhomogenen Materialzusammensetzung des auf der Indikatorschicht angeordneten Materials in der Haupterstreckungsebene der Halbleiterschichten kann so die Indikatorschicht in den vorgegebenen Bereichen vollständig freigelegt werden. Eine auf dem aktiven Bereich verbleibende Dicke des Halbleitermaterials kann also in diesen Bereichen konstant oder zumindest weitgehend konstant ausgebildet werden.

Erfindungsgemäß enthält die Indikatorschicht AlₓIn_{y}Ga_{1-x-y}N und weist weiterhin bevorzugt einen höheren Aluminium-Gehalt auf als das der Indikatorschicht in Abtragrichtung gesehen unmittelbar vorgeordnete Material.

Weiterhin bevorzugt enthält das Prozessgas zumindest zeitweise Sauerstoff. Durch Zugabe von Sauerstoff zu dem Prozessgas kann das Abtragverfahren bezüglich des Aluminiumgehalts der Halbleiterschichten eine hohe Selektivität aufweisen. Insbesondere kann die Abtragrate umso niedriger sein, je höher der Aluminiumgehalt ist.

Das Abtragen des Halbleitermaterials kann auch über die Indikatorschicht hinaus erfolgen. Insbesondere kann das Verfahren derart durchgeführt werden, dass das Abtragverfahren zunächst beim Erreichen der Indikatorschicht gestoppt oder zumindest verlangsamt wird. Nachfolgend kann das Verfahren modifiziert weitergeführt werden, so dass die Indikatorschicht in den freigelegten Bereichen entfernt wird. Weitergehend kann auch in Abtragrichtung gesehen der Indikatorschicht nachgeordnetes Material entfernt werden.

Durch das Stoppen beziehungsweise die Verlangsamung der Abtragung an der Indikatorschicht kann zunächst Material der Halbleiterschichtenfolge bis zu einem Abstand vom aktiven Bereich abgetragen werden, der bereits bei der Abscheidung der Halbleiterschichtenfolge über den Abstand der Oberseite der Indikatorschicht vom aktiven Bereich vorgegeben ist. Diese Abtragung bis zu einem vorgegebenen Abstand zum aktiven Bereich kann unabhängig von der tatsächlichen Abtragrate und mit einer hohen Homogenität entlang der Haupterstreckungsebene der Halbleiterschichten erfolgen.

Nachfolgend kann die Indikatorschicht und weiterhin darunter liegendes Halbleitermaterial bereichsweise entfernt werden, so dass Material der Indikatorschicht lediglich im stegartigen Bereich verbleibt.

Insbesondere kann das trockenchemische Abtragverfahren nach dem Erreichen der Indikatorschicht derart modifiziert werden, dass Material der Indikatorschicht mit einer erhöhten Abtragrate abgetragen wird.

In einer bevorzugten Ausgestaltung wird das Verfahren für eine Mehrzahl von Halbleiterschichtenfolgen durchgeführt, wobei die Halbleiterschichtenfolgen jeweils auf separaten Trägern bereitgestellt werden. So kann das Verfahren gleichzeitig für mehrere Halbleiterschichtenfolgen durchgeführt werden, wodurch der Durchsatz bei der Herstellung der Halbleiterbauelemente erhöht werden kann.

Mit dem beschriebenen Verfahren wird ein weiter oben beschriebenes Halbleiterbauelements hergestellt.

Weitere Merkmale, vorteilhafte Ausgestaltungen und Zweckmäßigkeiten ergeben sich aus der folgenden Beschreibung in Verbindung mit den Figuren.

Es zeigen:
Figur 1 ein Halbleiterbauelement in schematischer Schnittansicht,
Figur 2 ein Halbleiterbauelement in schematischer Schnittansicht,
Figur 3 ein Halbleiterbauelement in schematischer Schnittansicht,
die Figuren 4A und 4B ein Ausführungsbeispiel für ein Verfahren zur Herstellung eines Halbleiterbauelements anhand von jeweils in schematischer Schnittansicht dargestellten Zwischenschritten, und
die Figuren 5A bis 5C ein Ausführungsbeispiel für ein Verfahren zur Herstellung eines Halbleiterbauelements anhand von jeweils in schematischer Schnittansicht dargestellten Zwischenschritten.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

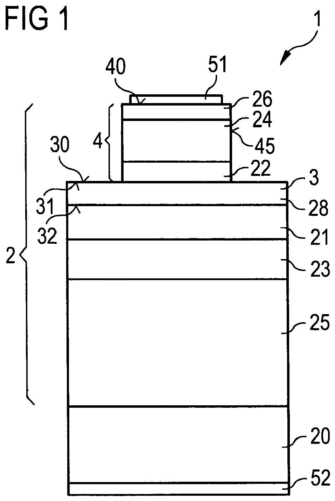

Ein Halbleiterbauelement 1 ist in Figur 1 in schematischer Schnittansicht gezeigt. Das Halbleiterbauelement 1 ist als ein kantenemittierender Halbleiterlaser in Rippenwellenleiter-Geometrie ausgebildet und weist einen Halbleiterkörper 2 mit einer Halbleiterschichtenfolge auf. Die Halbleiterschichtenfolge, die den Halbleiterkörper bildet, ist vorzugsweise epitaktisch, etwa mittels MOVPE oder MBE abgeschieden. Der Halbleiterkörper 2 ist auf einem Träger 20 angeordnet. Der Träger 20 kann beispielsweise ein Aufwachssubstrat für die Halbleiterschichtenfolge sein. Alternativ kann der Träger 20 auch von dem Aufwachssubstrat für die Halbleiterschichtenfolge verschieden sein.

Die Halbleiterschichtenfolge weist einen aktiven Bereich 21 auf, der zur Erzeugung kohärenter Laserstrahlung vorgesehen ist. Weiterhin umfasst die Halbleiterschichtenfolge eine Indikatorschicht 3. Der Halbleiterkörper 2 weist eine Grenzfläche 30 auf, die den Halbleiterkörper in vertikaler Richtung bereichsweise begrenzt. Auf der dem aktiven Bereich 21 abgewandten Seite der Indikatorschicht 3 ist ein stegartiger Bereich 4 ausgebildet. Der stegartige Bereich 4 erstreckt sich in vertikaler Richtung zwischen einer Oberfläche 40 des Halbleiterkörpers 2 und der Grenzfläche 30. Die Indikatorschicht weist eine vom aktiven Bereich 21 abgewandte Oberseite 31 und eine dem aktiven Bereich zugewandte Unterseite 32 auf. Die Grenzfläche ist mittels der Indikatorschicht 3 gebildet.

Insbesondere kann die Grenzfläche 30 zur Oberseite 31 der Indikatorschicht 3 einen Abstand von höchstens 100 nm, bevorzugt höchstens 50 nm aufweisen. Weitergehend kann die Grenzfläche 30 mittels der Oberseite 31 der Indikatorschicht gebildet sein, so dass der Abstand der Indikatorschicht 3 von der Oberfläche 40 dem Abstand der Grenzfläche 30 von der Oberfläche 40 entspricht.

In vertikaler Richtung erstreckt sich der stegartige Bereich 4 also bis zu der Indikatorschicht 3. Eine Seitenfläche 45 des stegartigen Bereichs 4 erstreckt sich senkrecht zu einer Haupterstreckungsebene der Halbleiterschichten des Halbleiterkörpers 2.

In lateraler Richtung bedeckt der stegartige Bereich 4 die Grenzfläche 30 nur bereichsweise. Weiterhin weist der stegartige Bereich in lateraler Richtung eine geringere Ausdehnung auf als der aktive Bereich 21. Die Ausbreitung der Mode der im Betrieb im aktiven Bereich 21 verstärkten Strahlung in lateraler Richtung kann so begrenzt werden.

Ferner weist die Halbleiterschichtenfolge eine Wellenleiterschicht 22 und eine weitere Wellenleiterschicht 23 auf, in denen die im aktiven Bereich 21 im Betrieb erzeugte und weiterhin zu verstärkende Strahlung propagiert. Auf der dem aktiven Bereich 21 abgewandten Seite der Wellenleiterschicht 22 und der dem aktiven Bereich abgewandten Seite der weiteren Wellenleiterschicht 23 ist eine Mantelschicht 24 beziehungsweise eine weitere Mantelschicht 25 angeordnet. Die Mantelschichten weisen zweckmäßigerweise einen Brechungsindex auf, der kleiner ist als der Brechungsindex der jeweils angrenzenden Wellenleiterschichten.

Auf der dem aktiven Bereich 21 abgewandten Seite der Mantelschicht 24 weist der Halbleiterkörper eine Anschlussschicht 26 auf. Die Anschlussschicht weist zweckmäßigerweise denselben Leitungstyp auf wie die zwischen der Anschlussschicht und dem aktiven Bereich 21 angeordnete Mantelschicht.

Weiterhin weist das Halbleiterbauelement 1 einen ersten Kontakt 51 und einen zweiten Kontakt 52 auf, die zur externen elektrischen Kontaktierung des Halbleiterkörpers 2 vorgesehen sind. Die Kontakte 51, 52 sind derart elektrisch leitend mit dem Halbleiterkörper verbunden, dass im Betrieb des Halbleiterbauelements über diese Kontakte Ladungsträger von zwei verschiedenen Seiten in den aktiven Bereich 21 injiziert werden können und dort unter Emission von Strahlung rekombinieren können.

In dem gezeigten Ausführungsbeispiel werden die Ladungsträger vom ersten Kontakt 51 über die Anschlussschicht 26 in den aktiven Bereich 21 injiziert. Die Anschlussschicht 26 bildet hierbei die Oberfläche 40 des stegartigen Bereichs 4. Davon abweichend kann auf die Anschlussschicht 26 auch verzichtet werden. In diesem Fall kann der erste Kontakt 51 unmittelbar an die Mantelschicht angrenzen.

Die Kontaktschichten enthalten vorzugsweise ein Metall, etwa Gold, Titan, Platin, Aluminium, Silber, Palladium, Rhodium oder Nickel oder eine metallische Legierung mit zumindest einem der genannten Metalle.

Im Folgenden wird die Materialzusammensetzung des Halbleiterkörpers für ein Halbleiterbauelement beschrieben, das für die Erzeugung von Strahlung im ultravioletten und blauen Spektralbereich vorgesehen ist. Die Halbleiterschichten des Halbleiterkörpers 2 enthalten jeweils das nitridische Verbindungshalbleitermaterial AlₓIn_{y}Ga_{1-x-y}N. Die Indikatorschicht 3 enthält einen größeren Aluminiumgehalt als die an die Indikatorschicht 3 angrenzende Wellenleiterschicht 22 des stegartigen Bereichs 4.

Der Aluminiumgehalt der Indikatorschicht beträgt mindestens 50 %. Weiterhin ist das Material derart gewählt, dass die Indikatorschicht bezüglich GaN gitterangepasst ist. Beispielsweise weist eine Schicht mit einem Aluminiumgehalt von 82 % und einem Indiumgehalt von 18 % die gleiche Gitterkonstante auf wie GaN.

Gegenüber einer AlₓGa₁₋ₓN-Halbleiterschicht kann bei einer AlₓIn_{y}Ga_{1-x-y}N-Schicht durch Zugabe von Indium die Abnahme der Gitterkonstante mit zunehmendem Aluminiumgehalt vollständig oder zumindest weitgehend kompensiert werden. So kann der Aluminium-Gehalt erhöht werden, ohne dass hierbei die Verspannung gegenüber Galliumnitrid zunimmt.

Weiterhin nimmt mit Zunahme des Aluminiumgehalts die Bandlücke von AlₓIn_{y}Ga_{1-x-y}N zu. Die Indikatorschicht 3 kann somit verglichen mit dem aktiven Bereich 21 eine hohe Bandlücke aufweisen und die Funktion einer Ladungsträgerbarriere 28 erfüllen.

Die auf unterschiedlichen Seiten des aktiven Bereichs 21 angeordneten Halbleiterschichten weisen vorzugsweise zueinander entgegengesetzte Leitungstypen auf. Beispielsweise können die Halbleiterschichten des stegartigen Bereichs 4 und der Indikatorschicht 3 p-leitend dotiert und die zwischen dem aktiven Bereich 21 und dem Träger 20 angeordneten Halbleiterschichten n-leitend dotiert sein. In diesem Fall kann die Indikatorschicht 3 als eine Elektronenbarriere ausgeführt sein. Für eine hinreichend hohe Durchlässigkeit für Löcher ist die Indikatorschicht in diesem Fall vorzugsweise stark p-leitend dotiert, beispielsweise mit Magnesium.

Die als Ladungsträgerbarriere dienende Indikatorschicht 3 kann unmittelbar an den aktiven Bereich 21 angrenzen.

Davon abweichend kann die Indikatorschicht auch vom aktiven Bereich beabstandet ausgeführt sein. Der Abstand beträgt vorzugsweise höchstens 400 nm, besonders bevorzugt höchstens 300 nm. Der Abstand kann weitergehend verringert sein und höchstens 150 nm, bevorzugt höchstens 120 nm, am meisten bevorzugt höchstens 70 nm, betragen. Je näher die Ladungsträgerbarriere an dem aktiven Bereich angeordnet ist, desto stärker kann die Rekombination von Ladungsträgern auf den aktiven Bereich 21 beschränkt werden. Der Anteil der in den Halbleiterkörper 2 injizierten Ladungsträger, der im aktiven Bereich 21 unter Emission von Strahlung rekombiniert, kann so gesteigert werden. Dadurch kann die Laser-Schwelle gesenkt und die Steilheit der Kennlinie der Leistung der erzeugten Strahlung als Funktion des injizierten Stroms (P-I-Kennlinie) erhöht werden.

Von dem anhand der Figur 1 beschriebenen Halbleiterbauelement 1 abweichend kann die Oberseite 31 der Indikatorschicht 3 auch von der Grenzfläche 30 beabstandet sein, wobei die Oberseite der Indikatorschicht zur Oberfläche 40 einen geringeren Abstand aufweist als die Grenzfläche zur Oberfläche 40. In diesem Fall ragt die Indikatorschicht also in den stegartigen Bereich 4 hinein.

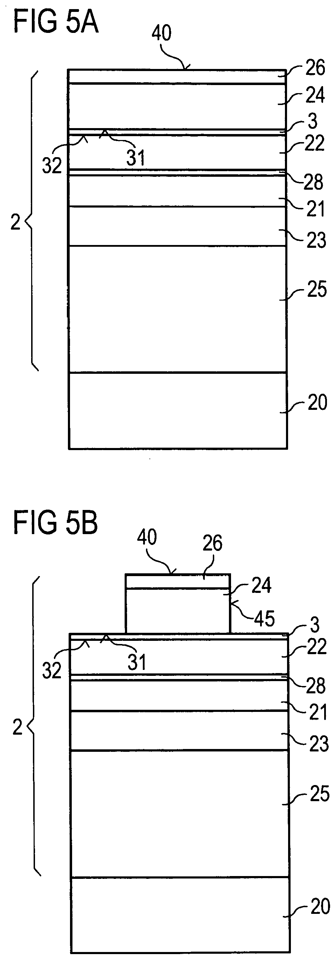

Weitergehend kann die Indikatorschicht 3 auch vollständig innerhalb des stegartigen Bereichs 4 angeordnet sein. In diesem Fall ist die Grenzfläche 30 also außerhalb der Indikatorschicht ausgebildet. Der Abstand der Unterseite 32 des stegartigen Bereichs zur Grenzfläche beträgt bevorzugt höchstens 70 nm, besonders bevorzugt höchstens 50 nm. Die Herstellung eines solchen Halbleiterbauelements wird im Zusammenhang mit den Figuren 5A bis 5C beschrieben.

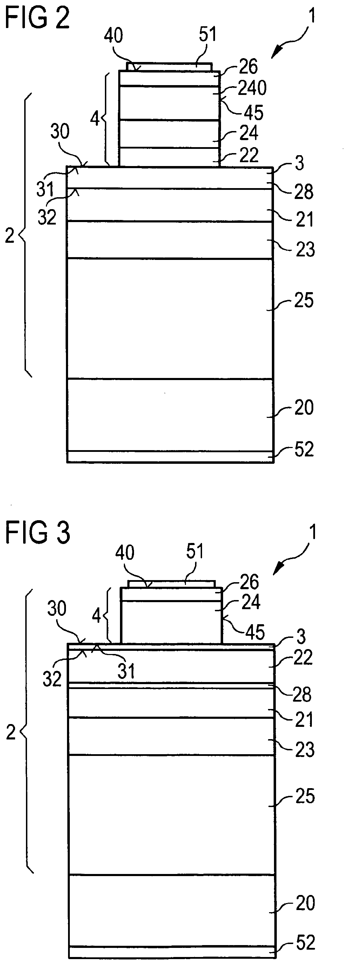

Ein weiteres Halbleiterbauelement ist in Figur 2 schematisch in Schnittansicht dargestellt. Dieses Halbleiterbauelement 1 entspricht im Wesentlichen dem im Zusammenhang mit Figur 1 beschriebenen Halbleiterbauelement 1. Im Unterschied hierzu weist die Mantelschicht 24, insbesondere der stegartige Bereich 4, eine Teilschicht 240 auf, die AlₓIn_{y}Ga_{1-x-y}N mit einem von Null verschiedenen Indium-Gehalt enthält.

Mit dieser Teilschicht 240 kann die Mantelschicht 24 gegenüber einer AlₓGa₁₋ₓN-Mantelschicht mit gleichem Aluminiumgehalt eine geringere Verspannung gegenüber Galliumnitrid aufweisen. Die Verspannung des Halbleiterkörpers 2 kann so reduziert werden.

Der Aluminiumgehalt der Teilschicht 240 der Mantelschicht 24 kann geringer sein als der Aluminiumgehalt der Indikatorschicht 3. Die Herstellung eines stegartigen Bereichs 4, der sich bis zur Indikatorschicht 3 erstreckt, wird so vereinfacht.

Davon abweichend kann der Aluminiumgehalt der Teilschicht 240 der Mantelschicht 24 auch höher sein als der Aluminiumgehalt der Indikatorschicht 3. In diesem Fall weist das unmittelbar auf der dem aktiven Bereich 21 abgewandten Seite der Indikatorschicht 3 angeordnete Material des stegartigen Bereichs 4 vorzugsweise einen geringeren Aluminiumgehalt auf als die Indikatorschicht 3. Die Dicke dieses Materials mit geringerem Aluminiumgehalt beträgt vorzugsweise eine Dicke zwischen einschließlich 20 nm und 400 nm, besonders bevorzugt zwischen einschließlich 50 nm und einschließlich 300 nm, beispielsweise 150 nm.

Von diesem Halbleiterbauelement 1 abweichend kann die Teilschicht 240 auch auf der dem stegartigen Bereich 4 abgewandten Seite des aktiven Bereichs 21 angeordnet sein. Weiterhin kann auch auf beiden Seiten des aktiven Bereichs jeweils eine solche Teilschicht ausgebildet sein. Es können auch mehrere solche Teilschichten vorgesehen sein. Die Verspannung des Halbleiterkörpers kann so weitergehend verringert werden.

Ein weiteres Halbleiterbauelement ist in Figur 3 in schematischer Schnittansicht dargestellt. Dieses Halbleiterbauelement 1 entspricht im Wesentlichen dem in Zusammenhang mit Figur 1 beschriebenen Halbleiterbauelement 1. Im Unterschied hierzu ist die Indikatorschicht 3 separat von der Ladungsträgerbarriere 28 ausgeführt, wobei die Indikatorschicht 3 und die Ladungsträgerbarriere 28 auf derselben Seite des aktiven Bereichs 21 angeordnet sind. Zwischen der Ladungsträgerbarriere 28 und der Indikatorschicht 3 ist die Wellenleiterschicht 22 angeordnet. Die Indikatorschicht 3 ist also auf der dem aktiven Bereich 21 abgewandten Seite der Wellenleiterschicht 22 angeordnet.

Die Indikatorschicht 3, insbesondere bezüglich des Materials, kann weitgehend unabhängig von der Ladungsträgerbarriere 28 ausgebildet sein. Weiterhin kann der Abstand des stegartigen Bereichs 4 vom aktiven Bereich 21 unabhängig von der Position der Ladungsträgerbarriere 28 eingestellt werden.

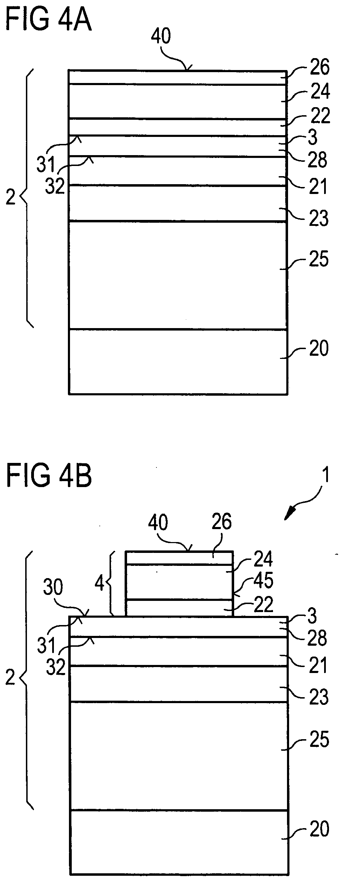

Ein Ausführungsbeispiel für ein Verfahren zur Herstellung eines Halbleiterbauelements ist in den Figuren 4A und 4B anhand von schematisch in Schnittansicht dargestellten Zwischenschritten gezeigt. Hierbei wird das Verfahren exemplarisch anhand der Herstellung eines Halbleiterbauelements beschrieben, das wie im Zusammenhang mit Figur 1 beschrieben ausgeführt ist.

Eine Halbleiterschichtenfolge 2 wird auf einem Träger 20 bereitgestellt (Figur 4A). Zur vereinfachten Darstellung ist lediglich ein Teil der Halbleiterschichtenfolge gezeigt, aus dem ein Halbleiterkörper für ein Halbleiterbauelement hervorgeht. Es können aber auch mehrere Halbleiterkörper gleichzeitig nebeneinander ausgebildet werden.

Die Halbleiterschichtenfolge 2 umfasst einen zur Erzeugung von Strahlung vorgesehenen aktiven Bereich 21 und eine Indikatorschicht 3. Von einer dem Träger 20 abgewandten Seite der Halbleiterschichtenfolge 2 her wird Material der Halbleiterschichtenfolge bereichsweise mittels eines trockenchemischen Verfahrens abgetragen (Figur 4B).

Hierfür eignet sich beispielsweise reaktives Ionenätzen, etwa ICP-RIE (inductively coupled plasma RIE) oder parallel plate RIE, oder chemisch assistiertes Ionenstrahlätzen. Während des trockenchemischen Abtragens wird eine Eigenschaft eines Prozessgases, etwa eines Plasmas mit Anteilen des gerade abgetragenen Materials, überwacht. Insbesondere kann während des Abtragens durch das Überwachen des Prozessgases die Materialzusammensetzung des gerade abgetragenen Halbleitermaterials ermittelt werden.

Beim Erreichen der Indikatorschicht 3 ändert sich die überwachte Eigenschaft des Prozessgases, so dass das Erreichen einer vorgegebenen Abtragtiefe angezeigt wird. Die Genauigkeit, mit der die tatsächliche Abtragtiefe die vorgegebene Abtragtiefe erreicht, ist somit weitgehend unabhängig von der tatsächlichen Abtragrate.

Beispielsweise kann die spektrale Zusammensetzung der von dem Prozessgas abgestrahlten Strahlung überwacht werden. Anhand der Intensität der in einem für das abzutragende Material charakteristischen spektralen Bereich abgestrahlten Strahlung kann so auf die Materialzusammensetzung des gerade abgetragenen Materials geschlossen werden. Beispielsweise kann eine Zunahme des Aluminium-Gehalts im abgetragenen Material durch eine Zunahme der Strahlungsleistung in einem für Aluminium charakteristischen spektralen Bereich nachgewiesen werden.

Bezüglich der Materialzusammensetzung unterscheidet sich die Indikatorschicht 3 derart von dem in Abtragrichtung gesehen vorgeordneten Halbleitermaterial, dass sich das Erreichen der Indikatorschicht in einer signifikanten Änderung der spektralen Intensitätsverteilung des Prozessgases niederschlägt.

Beispielsweise kann die Indikatorschicht 3 einen Aluminiumgehalt aufweisen, der höher ist als der Aluminiumgehalt des der Indikatorschicht in Abtragrichtung unmittelbar vorgeordneten Materials. Es eignet sich eine AlInGaN-Indikatorschicht mit einem Aluminiumgehalt von mindestens 50 %. Die Indikatorschicht kann insbesondere frei von Gallium ausgeführt sein. Beispielsweise kann die Indikatorschicht einen Aluminiumgehalt von 82 % und einen Indiumgehalt von 18 % aufweisen. Eine solche Halbleiterschicht ist an eine GaN-Schicht gitterangepasst.

Eine Selektivität der Abtragrate bezüglich des Aluminiumgehalts kann beispielsweise durch Zugabe von Sauerstoff in das Prozessgas erhöht werden. Je höher der Aluminiumgehalt ist, desto geringer ist die Ätzrate in diesem Fall. So kann erzielt werden, dass der Abtragprozess bei Erreichen der Indikatorschicht 3 nahezu vollständig gestoppt wird. Der Indikatorschicht vorgeordnetes Material kann weitgehend unabhängig von Schichtdickeschwankungen in den vorgegebenen Bereichen vollständig abgetragen werden. Inhomogenitäten der Schichtdicke und/oder der Materialzusammensetzung des abzutragenden Materials entlang der Haupterstreckungsebene der Halbleiterschichten können so auf einfache Weise ausgeglichen werden. Die bei der Herstellung der Halbleiterbauelemente erzielbare Ausbeute kann so gesteigert werden.

Zur externen elektrischen Kontaktierung des Halbleiterbauelements können auf dem Halbleiterkörper 2 wie im Zusammenhang mit Figur 1 beschrieben Kontaktflächen, etwa mittels Aufdampfens oder Sputterns, abgeschieden werden (in Figur 4B nicht explizit dargestellt).

Mit dem beschriebenen Verfahren kann allgemein eine Ausnehmung in einer Halbleiterschichtenfolge ausgebildet werden, deren Tiefe über die Position der Indikatorschicht 3 bereits bei der Herstellung der Halbleiterschichtenfolge vorgegeben werden kann. Im Unterschied zu einem Ätzverfahren, bei dem die Ätztiefe über das Produkt aus zu erwartender Ätzrate und Ätzdauer eingestellt wird, kann bei dem beschriebenen Verfahren die vorgegebene Abtragtiefe auch bei Abweichungen der Ätzrate erreicht werden.

Das beschriebene Verfahren zeichnet sich insbesondere dadurch aus, dass die Dicke des nach Abschluss des Abtragens unter dem abgetragenen Material verbleibenden Halbleitermaterials nicht oder nur geringfügig von Schwankungen der Schichtdicke und/oder der Materialzusammensetzung des abzutragenden Materials abhängt. Insbesondere kann das Verfahren gleichzeitig für eine Mehrzahl von Halbleiterschichtenfolgen durchgeführt werden, ohne dass fertigungsbedingte Schwankungen zwischen den verschiedenen Halbleiterschichtenfolgen die Ausbeute funktionstüchtiger Halbleiterbauelemente wesentlich gefährden. Es können also in einem Verfahrensschritt mehrere Halbleiterschichtenfolgen, die beispielsweise jeweils auf einem Wafer abgeschieden sind, gleichzeitig dem Abtragprozess unterzogen werden.

Ein weiteres Ausführungsbeispiel für ein Verfahren zur Herstellung eines Halbleiterbauelements ist in den Figuren 5A bis 5C anhand von schematisch in Schnittansicht dargestellten Zwischenschritten gezeigt. Dieses Ausführungsbeispiel entspricht im Wesentlichen dem im Zusammenhang mit den Figuren 4A und 4B beschriebenen Ausführungsbeispiel. Im Unterschied hierzu ist die Halbleiterschichtenfolge des Halbleiterkörpers 2 wie im Zusammenhang mit Figur 3 beschrieben ausgeführt. Die Indikatorschicht 3 ist also vom aktiven Bereich 21 beabstandet (Figur 5A).

Wie in Figur 5B dargestellt wird die Indikatorschicht 3 bereichsweise freigelegt. Dies kann wie im Zusammenhang mit Figur 4B beschrieben erfolgen. So kann das auf der Indikatorschicht angeordnete Material unabhängig von der tatsächlichen Abtragrate bis zu einem vorgegebenen Abstand vom aktiven Bereich entfernt werden.

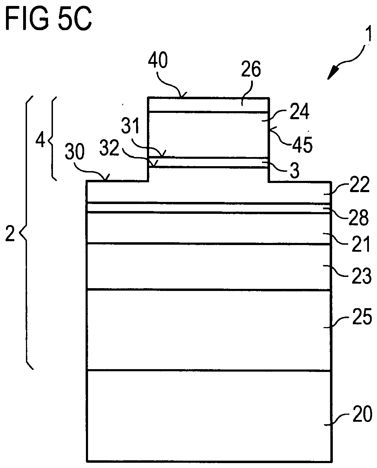

Nachfolgend kann das Abtragverfahren derart modifiziert fortgeführt werden, dass Material der Indikatorschicht 3 mit einer erhöhten Abtragrate entfernt wird (Figur 5C). Die erhöhte Abtragrate kann beispielsweise durch eine Reduktion oder ein vollständiges Einstellen der Zugabe von Sauerstoff zu dem Prozessgas erzielt werden. Auf diese Weise kann der stegartige Bereich 4 so hergestellt werden, dass die Indikatorschicht 3 in dem stegartigen Bereich verläuft. Weiterhin kann auch Material der darunter liegenden Wellenleiterschicht 22 entfernt werden. Die Grenzfläche 30 wird mittels der Wellenleiterschicht 22 gebildet. Von dem gezeigten Ausführungsbeispiel abweichend kann die Grenzfläche auch mittels einer anderen Schicht gebildet sein, die zwischen dem aktiven Bereich 21 und der Indikatorschicht 3 angeordnet ist, beispielsweise mittels der Ladungsträgerbarriere 28.

## Patentansprüche

1. Verfahren zur Herstellung eines Halbleiterbauelements (1), bei dem eine Halbleiterschichtenfolge (2) mit einem zur Erzeugung von Strahlung vorgesehenen aktiven Bereich (21) bereitgestellt wird,
wobei
- die Halbleiterschichtenfolge mit einer Indikatorschicht (3) bereitgestellt wird;
- auf der dem aktiven Bereich (21) abgewandten Seite der Indikatorschicht (3) angeordnetes Material der Halbleiterschichtenfolge (2) mittels trockenchemischen Abtragens der Halbleiterschichtenfolge (2) bereichsweise entfernt wird;
- eine Eigenschaft eines Prozessgases während des Abtragens überwacht wird und das Erreichen der Indikatorschicht (3) mittels der Änderung der Eigenschaft des Prozessgases ermittelt wird, das mit dem Verfahren hergestellte Halbleiterbauelement ein kantenemittierendes Halbleiterlaserbauelement in Rippenwellenleitergeometrie ist,
**dadurch gekennzeichnet, dass**
- die Indikatorschicht (3) AlₓIn_{y}Ga_{1-x-y}N mit 0,5 ≤ x ≤ 1, 0 ≤ y ≤ 1 und x + y ≤ 1 enthält und bezogen auf GaN gitterangepasst ist.

2. Verfahren nach Anspruch 1,
bei dem mittels der überwachten Eigenschaft des Prozessgases eine Änderung der Materialzusammensetzung des abgetragenen Halbleitermaterials der Halbleiterschichtenfolge (2) ermittelt wird.

3. Verfahren nach Anspruch 1 oder 2,
bei dem das trockenchemische Abtragverfahren und die Indikatorschicht (3) derart aufeinander abgestimmt sind, dass Material der Indikatorschicht (3) langsamer abgetragen wird als Material der Halbleiterschichtenfolge (2), das der Indikatorschicht (3) in Abtragrichtung gesehen unmittelbar vorgeordnet ist.

4. Verfahren nach Anspruch 3,
bei dem das trockenchemische Abtragverfahren nach dem Erreichen der Indikatorschicht (3) derart modifiziert wird, dass Material der Indikatorschicht (3) mit einer erhöhten Abtragrate abgetragen wird.

5. Verfahren nach einem der vorhergehenden Ansprüche,
bei dem die überwachte Eigenschaft eine spektrale Abstrahlcharakteristik des Prozessgases ist.

6. Verfahren nach einem der vorhergehenden Ansprüche,
bei dem das Prozessgas zumindest zeitweise Sauerstoff enthält.

7. Verfahren nach einem der vorhergehenden Ansprüche,
bei dem ein Halbleiterbauelement hergestellt wird, das einen Halbleiterkörper (2) mit einer Grenzfläche (30) aufweist, die den Halbleiterkörper (2) in vertikaler Richtung bereichsweise begrenzt;
- der Halbleiterkörper (2) auf der dem aktiven Bereich (21) abgewandten Seite der Grenzfläche (30) einen stegartigen Bereich (4) aufweist, der sich in vertikaler Richtung zwischen der Grenzfläche (30) und einer Oberfläche (40) des Halbleiterkörpers (2) erstreckt; und
- ein Abstand der Indikatorschicht (3) von der Oberfläche (40) höchstens so groß ist wie ein Abstand der Grenzfläche (30) von der Oberfläche (40).

8. Verfahren nach Anspruch 7,
wobei ein Abstand der Indikatorschicht (3) von der Grenzfläche (30) höchstens 70 nm beträgt.

9. Verfahren nach Anspruch 7,
wobei die Grenzfläche (30) mittels der Indikatorschicht (3) gebildet ist.

10. Verfahren nach einem der Ansprüche 7 bis 9,
wobei auf der dem stegartigen Bereich (4) zugewandten Seite des aktiven Bereichs (21) eine Ladungsträgerbarriere (28) ausgebildet und die Ladungsträgerbarriere (28) mittels der Indikatorschicht (3) gebildet ist.

11. Verfahren nach einem der Ansprüche 7 bis 9,
wobei auf der dem stegartigen Bereich (4) zugewandten Seite des aktiven Bereichs (21) eine Ladungsträgerbarriere (28) ausgebildet ist, wobei die Indikatorschicht (3) von der Ladungsträgerbarriere (28) beabstandet ist.

12. Verfahren nach einem der Ansprüche 7 bis 11,
wobei auf der dem stegartigen Bereich (4) zugewandten Seite des aktiven Bereichs (21) eine Wellenleiterschicht (22) ausgebildet ist.

13. Verfahren nach Anspruch 12,
wobei die Indikatorschicht (3) zwischen der Wellenleiterschicht (22) und dem aktiven Bereich (21) angeordnet ist und wobei die Indikatorschicht (3) einen höheren Al-Gehalt aufweist als das an die Indikatorschicht (3) angrenzende Material des stegartigen Bereichs (4).

14. Verfahren nach Anspruch 12,
wobei die Indikatorschicht (3) auf der dem aktiven Bereich (21) abgewandten Seite der Wellenleiterschicht (22) angeordnet ist oder in der Wellenleiterschicht (22) ausgebildet ist.

15. Verfahren nach einem der 7 bis 14,
wobei zumindest auf einer Seite des aktiven Bereichs (21) eine Mantelschicht (24) mit einer Teilschicht (240) angeordnet ist, und wobei die Teilschicht Indium enthält.

## Claims

1. A method for producing a semiconductor component (1), in which a semiconductor layer sequence (2) is provided with an active region (21) for generating radiation,
wherein
- the semiconductor layer sequence is provided with an indicator layer (3);
- a material of the semiconductor layer sequence (2) arranged on the side of the indicator layer (3) facing away from the active region (21) is removed in regions by means of dry-chemical removal of the semiconductor layer sequence (2);
- a property of a process gas is monitored during the removal and the reaching of the indicator layer (3) is determined by means of the change in the property of the process gas,
- the semiconductor laser component (1) produced by the method is an edge-emitting semiconductor laser component in rib waveguide geometry,
**characterized in that**
- the indicator layer (3) comprises AlₓIn_{y}Ga_{1-x-y}N wherein 0,5 ≤ x ≤ 1, 0 ≤ y ≤ 1 and x + y ≤ and is lattice-matched in relation to GaN.

2. The method according to claim 1,
in which by means of the monitored property of the process gas a change in the material composition of the removed semiconductor material of the semiconductor layer sequence (2) is determined.

3. The method according to claim 1 or 2,
in which the dry-chemical removal process and the indicator layer (3) are matched to one another in such a way that material of the indicator layer (3) is removed more slowly than the material of the semiconductor layer sequence (2) which is arranged immediately upstream of the indicator layer (3) when viewed in the removal direction.

4. The method according to claim 3,
in which the dry-chemical removal method is modified after reaching the indicator layer (3) is in such a way that material of the indicator layer (3) is removed at an increased removal rate.

5. The method according to one of the preceding claims,
in which the monitored property is a spectral emission characteristic of the process gas.

6. The method according to one of the preceding claims,
in which the process gas contains oxygen at least at times.

7. The method according to one of the preceding claims, in which a semiconductor component is produced which comprises a semiconductor body (2) having an interface (30) which delimits the semiconductor body (2) in regions in the vertical direction;
- the semiconductor body (2) has a ridge-like region (4) on the side of the interface (30) facing away from the active region (21), the ridge-like region (4) extends in the vertical direction between the interface (30) and a surface (40) of the semiconductor body (2); and
- a distance of the indicator layer (3) from the surface (40) is at most as large as a distance of the interface (30) from the surface (40).

8. The method according to claim 7,
wherein a distance of the indicator layer (3) from the interface (30) is at most 70 nm.

9. The method according to claim 7,
wherein the interface (30) is formed by means of the indicator layer (3).

10. The method according to one of claims 7 to 9,
wherein a charge carrier barrier (28) is arranged on the side of the active region (21) facing the ridge-like region (4) and the charge carrier barrier (28) is formed by means of the indicator layer (3).

11. The method according to one of claims 7 to 9,
wherein a charge carrier barrier (28) is arranged on the side of the active region (21) facing the ridge-like region (4), wherein the indicator layer (3) is spaced apart from the charge carrier barrier (28).

12. The method according to one of claims 7 to 11,
wherein a waveguide layer (22) is formed on the side of the active region (21) facing the ridge-like region (4).

13. The method according to claim 12,
wherein the indicator layer (3) is arranged between the waveguide layer (22) and the active region (21), and
wherein the indicator layer (3) has a higher Al content than the material of the ridge-like region (4).

14. The method according to claim 12,
wherein the indicator layer (3) is arranged on the side of the waveguide layer (22) facing away from the active region (21) or is formed in the waveguide layer (22).

15. The method according to one of claims 7 to 14,
wherein at at least on one side of the active region (21) a cladding layer (24) is arranged, the cladding layer (24) has a partial layer (240), and wherein the partial layer contains indium.

## Revendications

1. Procédé en vue de la fabrication d'un composant semiconducteur (1), pour lequel une succession de couches semiconductrices (2) est mise à disposition avec une zone active prévue (21) pour la génération de rayonnement,
sachant que
- la succession de couches semiconductrices est mise à disposition avec une couche indicatrice (3) ;
- sur le côté détourné de la zone active (21) de la couche indicatrice (3), du matériau disposé de la succession de couches semiconductrices (2) est ôté par zones au moyen d'une élimination chimique à sec de la succession de couches semiconductrices (2) ;
- une propriété d'un gaz de processus est surveillée pendant l'élimination et l'arrivée à la couche indicatrice (3) est déterminée au moyen de la modification de la propriété du gaz de processus, le composant semiconducteur fabriqué avec le procédé est un composant laser à semiconducteur à émission par la tranche en géométrie à guide d'ondes nervuré,
**caractérisé en ce que**
la couche indicatrice (3) contient de l'AlₓIn_{y}Ga_{1-x-y}N avec 0,5 < x < 1, 0 < y < 1 et x + y < 1 et est adaptée à la structure cristalline par rapport à GaN.

2. Procédé selon la revendication 1,
pour lequel au moyen de la propriété surveillée du gaz de processus est déterminée une modification de la composition de matériau du matériau de semiconducteur éliminé de la succession de couches semiconductrices (2).

3. Procédé selon les revendications 1 ou 2,
pour lequel le procédé d'élimination chimique à sec et la couche indicatrice (3) sont appariés l'un à l'autre de manière à ce que du matériau de la couche indicatrice (3) est éliminé plus lentement que du matériau de la succession de couches semiconductrices (2), qui, vu dans le sens d'élimination, est disposé directement en avant de la couche indicatrice (3).

4. Procédé selon la revendication 3,
Pour lequel le procédé d'élimination chimique à sec est modifié après l'arrivée à la couche indicatrice (3) de sorte que du matériau de la couche indicatrice (3) est éliminé avec un taux d'élimination accru.

5. Procédé selon une quelconque des revendications précédentes, pour lequel la propriété surveillée est une caractéristique de rayonnement spectrale du gaz de processus.

6. Procédé selon une quelconque des revendications précédentes, pour lequel le gaz de processus contient au moins périodiquement de l'oxygène.

7. Procédé selon une quelconque des revendications précédentes, pour lequel un composant semiconducteur est fabriqué, qui présente un corps semiconducteur (2) avec une surface limite (30), qui limite le corps semiconducteur (2) par zone dans le sens vertical ;
- le corps semiconducteur (2) présente sur le côté détourné de la zone active (21) de la surface limite (30) une zone en nervure (4) qui s'étend dans la direction verticale entre la surface limite (30) et une surface (40) du corps semiconducteur (2) ; et
- un écart de la couche indicatrice (3) à partir de la surface (40) est au maximum aussi grand qu'un écart de la surface limite (30) à partir de la surface (40).

8. Procédé selon la revendication 7,
sachant qu'un écart de la couche indicatrice (3) à partir de la surface limite (30) s'élève à 70 nm maximum.

9. Procédé selon la revendication 7,
sachant que la surface limite (30) est constituée au moyen de la couche indicatrice (3).

10. Procédé selon une quelconque des revendications 7 à 9, pour lequel, sur le côté tourné vers la zone en nervure (4) de la zone active (21), une barrière porteuse de charge (28) est constituée et la barrière porteuse de charge (28) est constituée au moyen de la couche indicatrice (3).

11. Procédé selon une quelconque des revendications 7 à 9, pour lequel, sur le côté tourné vers la zone en nervure (4) de la zone active (21), une barrière porteuse de charge (28) est constituée, sachant que la couche indicatrice (3) est écartée de la barrière porteuse de charge (28).

12. Procédé selon une quelconque des revendications 7 à 11, pour lequel, sur le côté tourné vers la zone en nervure (4) de la zone active (21), une couche de guide d'ondes (22) est constituée.

13. Procédé selon la revendication 12,
sachant que la couche indicatrice (3) est disposée entre la couche de guide d'ondes (22) et la zone active (21) et sachant que la couche indicatrice (3) présente un taux d'Al plus élevé que le matériau adjacent à la couche indicatrice (3) de la zone en nervure (4).

14. Procédé selon la revendication 12,
sachant que la couche indicatrice (3) est disposée sur le côté détourné de la zone active (21) de la couche de guide d'ondes (22) ou constituée dans la couche de guide d'ondes (22).

15. Procédé selon une quelconque des revendications 7 à 14, sachant qu'au moins sur un côté de la zone active (21) est disposée une couche de placage (24) avec une couche partielle (240) et sachant que la couche partielle contient de l'indium.
